# EUROPÄISCHE PATENTSCHRIFT

(11) **EP 3 619 593 B1**
(45) Veröffentlichungstag und Bekanntmachung des Hinweises auf die Patenterteilung: **05.10.2022**
(21) Anmeldenummer: 17816471.1
(22) Anmeldetag: 21.11.2017
(51) Int. Cl.: G06F 3/01, H01L 41/047, H03K 17/96

(54) **VORRICHTUNG, DIE EIN HAPTISCHES FEEDBACK VERMITTELT UND BAUELEMENT MIT DER VORRICHTUNG**
DEVICE PROVIDING HAPTIC FEEDBACK, AND COMPONENT COMPRISING SAID DEVICE
DISPOSITIF TRANSMETTANT UNE RÉTROACTION HAPTIQUE ET ÉLÉMENT POURVU DE CE DISPOSITIF

(30) Priorität: 26.07.2017 AT 5014217 U
(43) Veröffentlichungstag der Anmeldung: 11.03.2020
(73) Patentinhaber: TDK Electronics AG, 81671 München (DE)
(72) Erfinder: RAJAPURKAR, Aditya, 8042 Graz (AT); PUCHLEITNER, Roman, 8083 St. Stefan (AT); NEUWIRTH, Daniel, 94474 Vilshofen (DE); PRALL, Maximillian, 8530 Deutschlandsberg (AT)
(74) Vertreter: Epping - Hermann - Fischer
(86) Internationale Anmeldenummer: PCT/EP2017/079883
(87) Internationale Veröffentlichungsnummer: WO 2019/020205

(56) Entgegenhaltungen:
- EP-A1- 2 315 101
- CN-U- 204 167 367
- DE-A1-102015 117 262
- US-A- 2 386 279
- US-A- 2 895 062
- US-A- 5 276 657
- US-A- 5 729 077
- US-A- 5 804 906
- US-A1- 2002 109 433
- US-A1- 2006 028 095
- US-A1- 2009 303 839
- US-A1- 2011 127 881
- US-A1- 2015 187 349
- US-B1- 6 465 936
- US-B1- 6 798 122
- US-B1- 6 798 888

## Beschreibung

Vorrichtung, die ein haptisches Feedback vermittelt und Bauelement mit der Vorrichtung Die vorliegende Erfindung betrifft ein Bauelement und eine Vorrichtung zur Erzeugung eines aktiven haptischen Feedbacks. Es handelt sich dabei um eine Vorrichtung, die dazu ausgestaltet ist, eine Rückmeldung an einen Nutzer zu erzeugen, wenn dieser eine Kraft auf das Bauelement ausübt. Ein solches Bauelement kann beispielsweise in einem Knopf, z.B. in einem Betätigungsknopf für Instrumente, eingesetzt werden. Das Bauelement kann das aktive haptische Feedback beispielsweise dazu erzeugen, um einem Nutzer mitzuteilen, dass von ihm vorgenommene Einstellungen erfolgreich von dem Bauelement umgesetzt werden.

Umgekehrt können auch Bauelemente aktives haptisches Feedback geben, beispielsweise können Mobiltelefone Vibrationsalarme erzeugen. Es sind auch taktile Displays für mobile elektronische Geräte wie Notebooks etc. bekannt. Das haptische Feedback kann auch die Stärke von Kräften oder die Beschaffenheit von Oberflächen oder die Steifheit oder Elastizität von Materialien in eine taktil wahrnehmbare Empfindung umsetzen.

Piezoelektrische Aktoren mit einem keramischen Grundkörper und einer darauf angeordneten die Auslenkung verstärkenden Zymbel sind aus US 5 729 077 A, US 2009/030839 A1 und aus US 2015/0187349 A1 bekannt. Aus der US 6 465 936 B1 ist elektromechanischer Wandler bekannt, bei dem an Stelle einer Zymbel eine ringförmig geschlossene Metallstruktur den keramischen Grundkörper umspannt. Aus US 2 386 279 A ist ein mit einem gebogenen flexiblen Material überspannter elektrostatischer Aktor bekannt, während aus US 2 895 062 A ein ringförmiges piezoelektrisches Element bekannt ist, welches mit einer metallischen Membran überspannt ist.

Aufgabe der vorliegenden Erfindung ist es, eine verbesserte Vorrichtung zur Erzeugung eines aktiven haptischen Feedbacks anzugeben.

Diese Aufgabe wird durch eine Vorrichtung gemäß dem vorliegenden Anspruch 1 gelöst. Vorteilhafte Ausgestaltungen der Erfindung gehen aus weiteren Ansprüchen hervor.

Es wird eine Vorrichtung zur Erzeugung eines aktiven haptischen Feedbacks angegeben. Das Feedback wird als aktives Feedback bezeichnet, da es von der Vorrichtung selbst erzeugt wird. Das Feedback wird als haptisches Feedback bezeichnet, da es ein Nutzer über seinen Tastsinn wahrnehmen kann.

Die Vorrichtung umfasst einen piezoelektrischen Aktor zur Erzeugung eines Feedbacks in Form einer haptisch wahrnehmbaren Auslenkung. Der Aktor umfasst einen flachen piezoelektrischen Grundkörper mit annähernd planparallelen Hauptoberflächen. Im Grundkörper sind erste und zweite Aktorelektroden vorgesehen, über die eine piezoelektrische Auslenkung des piezoelektrischen Aktors bewirkt werden kann.

Der Grundkörper ist so ausgestaltet, dass er eine auf den Grundkörper ausgeübte Kraft erkennt. Die ausgeübte Kraft wird durch ein piezoelektrisches Element in ein elektrisches Signal umgesetzt. Dieses kann direkt oder gegebenenfalls verstärkt an die Aktorelektroden angelegt werden.

Wird eine Spannung an die Aktorelektroden angelegt, so erzeugt der Grundkörper eine Längenausdehnung. Die Längenausdehnung kann senkrecht zur Normalen erfolgen, wobei die Normale senkrecht zur Hauptoberfläche des Grundkörpers steht. Eine solche Längenänderung wird auch als Querkontraktion bezeichnet. Die Richtung der Längenausdehnung ist dabei von der Polarität der angelegten Spannung und von der Polarisierung des piezoelektrischen Materials abhängig.

Die Längenänderung des gesamten Aktors erfolgt bevorzugt parallel zur ausgeübten Kraft, also entlang einer Normalen zu einer Hauptoberfläche des Aktors.

Da eine Querkontraktion des Grundkörpers in der xy Ebene für einen Nutzer, der eine Kraft parallel zur Normalen ausübt, schlecht wahrnehmbar ist, ist die Vorrichtung vorteilhaft dazu ausgestaltet, Längenänderungen des Grundkörpers entlang einer Richtung senkrecht zur Normalen in eine Längenausdehnung des Aktors parallel zur Normalen umzuwandeln.

Die Umwandlung erfolgt dadurch, dass auf einer oder beiden Hauptoberflächen des Grundkörpers ein kegelstumpfförmiges Blech befestigt ist, bei dem die stumpfen "Kegelspitzen" jeweils vom Grundkörper wegweisen. Ein solches Blech wird im Folgenden auch als Zymbel bezeichnet.

Die Zymbel ist dazu ausgestaltet, eine Längenausdehnung des Grundkörpers vertikal zur Normalen in eine Längenänderung parallel zur Normalen zu transformieren. Die Zymbel kann weiterhin dazu dienen, eine Längenänderung des Grundkörpers parallel zur Normalen, die infolge der Querkontraktion des Grundkörpers erfolgt, zu verstärken. Das kegelstumpfförmig gebogene beziehungsweise geformte Blech kann eine Querkontraktion aufnehmen und verformt sich dabei in die gewünschte Richtung, nämlich parallel zur Normalen. Diese Verformung kann dabei stärker ausfallen als die piezoelektrische Auslenkung in der gleichen Richtung. Mit je einer Zymbel auf beiden Hauptoberflächen des Grundkörpers wird daher eine gut wahrnehmbare Längenänderung der gesamten Vorrichtung bewirkt.

Damit das Blech der Zymbel unter Aktoreinwirkung elastisch merklich verformbar ist, kann es eine typische Dicke aufweisen, die z.B. bei Titan im Bereich zwischen 0,1 bis 0,4mm liegt.

Die Zymbel kann einen flachen Randbereich aufweisen, der auf einer der Hauptoberflächen des Grundkörpers aufliegt und dort befestigt ist. Die Befestigung erfolgt mit einem Klebstoff, vorzugsweise auf der Basis eines Epoxid haltigen Klebstoffs.

Unter der Zymbel ist ein Hohlraum eingeschlossen, in dem sich nach dem Aufsetzen der Zymbel oder spätestens beim thermischen Aushärten des Klebstoffs (z.B. bei 150°C) ein Überdruck bilden könnte. Dieser könnte beim durch die noch weiche Klebstoffschicht entweichen und dort zur Blasenbildung führen. Um dies zu vermeiden, ist die Zymbel mit einer Bohrung versehen. Der unter der Zymbel eingeschlossene Hohlraum kommuniziert über diese Bohrung mit der Umgebung, so dass ein Druckausgleich erfolgen kann. Ohne Überdruck ist aber die Blasenbildung weitgehend vermieden. Vergleichende Versuche haben gezeigt, dass die Bohrung auch keinerlei negative Auswirkungen auf das Verhalten des Aktors ausübt. Vorteil der verhinderten Blasenbildung ist eine verbesserte Beständigkeit und somit eine höhere Zuverlässigkeit des Aktors. Die Verklebung ist ohne eingeschlossene Blasen beständiger.

Der Aktor ist über die Kegelstümpfe der beiden Zymbeln zwischen einer Basis und einer Befestigungsplatte fixiert. Die Befestigungsplatte wiederum steht mit der Basis in Verbindung und ist mittels einer Vorspannung fixiert. Diese kann als Zug- oder Druckspannung wirken und z.B. jeweils über Federn eingestellt sein.

In einer Ausführungsform ist die Betätigungsplatte als Membran ausgebildet. Die Membran ist so angebracht, dass sie die Zymbeln und damit auch den Grundkörper mit einer in Richtung Basis wirkenden Vorspannung an der Basis fixiert. Somit fungiert die Membran auch als Mittel, die auf die eine Zug- oder Druckspannung in Richtung Basis ausüben.

In der anderen Ausführungsform ist die Betätigungsplatte parallel zur Oberfläche des Grundkörpers und damit parallel zur Basis ausgerichtet, liegt auf der Deckfläche der oberen Zymbel auf und ist vorzugsweise relativ zur Betätigungsplatte frei beweglich. Die Betätigungsplatte steht über dem Grundkörper an zumindest zwei Seiten, besser an allen Seiten über und ist im überstehenden Bereich über Federn mit der Basis verbunden, wobei die Federn unter Vorspannung stehen. Auf diese Weise ist gewährleistet, dass ein auf die Betätigungsplatte einwirkender Druck, beispielsweise der Fingerdruck eines Nutzers, sicher aufgenommen wird und zumindest der parallel zur Normalen wirkende Kraftanteil auf den Grundkörper übertragen wird. Die Betätigungsplatte kann so ausgestaltet sein, dass sie bei nicht vertikal einwirkender Betätigung/Krafteinwirkung ein wenig abkippen kann, und dennoch die Kraft auf den Grundkörper überträgt. Die Federverspannung führt dazu, dass sich die Betätigungsplatte nach Auslenkung wieder parallel zur Basis beziehungsweise parallel zur Hauptoberfläche des Grundkörpers ausrichtet.

In einer alternativen Ausführung wird der Grundkörper über Zymbeln zwischen der Basis und der Betätigungsplatte fixiert, wobei auf die Betätigungsplatte ein in Richtung Basis wirkender Federdruck ausgeübt wird. Dieser kann über Spiralfedern erzeugt werden, die sich an einem Bügel abstützen, der an der Basis befestigt und so angeordnet ist, dass er mit einem Bügelende vertikal über dem Grundkörper steht. Der Bügel kann auch eine Schiene sein, die beispielsweise ein zweifach gebogenes Querschnittsprofil aufweist. Ein unteres flaches Teil kann auf der Basis befestigt sein, während das obere flache Teil über dem Grundkörper steht. Anstelle eines Bügels kann das Halteelement auch als Hülse mit einem übergebördelten Rand ausgebildet sein, wobei die Hülse dann gleichzeitig eine Führung für die Längenausdehnung der gesamten Vorrichtung darstellt. Die unter Druckspannung zwischen Hülse beziehungsweise Bügel und Betätigungsplatte stehenden Spiralfedern bewirken dabei eine sichere Halterung und eine Rückführung in einer Ausgangsposition nach Betätigung der Vorrichtung beziehungsweise nach Auslenkung des piezoelektrischen Aktors.

Weiterhin weist die Zymbel eine Mantelfläche auf, die in Richtung der Normalen über der jeweiligen Hauptoberfläche absteht. An der stumpfen Kegelspitze weist die Zymbel eine Deckfläche auf, die annähernd parallel zur Oberfläche des Grundkörpers ausgerichtet ist.

Die Zymbel weist daher vorzugsweise eine runde Grundfläche auf, mit deren Hilfe Längenänderungen parallel zur Hauptoberfläche unabhängig vom Winkel zum Grundkörper am besten aufgenommen und durch Verformung des Bleches in einer Richtung parallel zur Normalen verstärkt werden können.

Die erfindungsgemäße Vorrichtung erzeugt ein haptisches Feedback, wenn eine auf den Grundkörper beziehungsweise die Vorrichtung ausgeübte Kraft erkannt wird. Das Erkennen kann mit Hilfe des inversen piezoelektrischen Effekts erfolgen. Die auf den Aktorelektroden umfassenden Grundkörper ausgeübte Kraft erzeugt eine Ladungsverschiebung, die an Elektroden als Messspannung abgegriffen werden kann. Dazu können prinzipiell die Aktorelektroden verwendet werden.

Möglich ist es jedoch auch, zumindest eine separate Messelektrode im Grundkörper anzuordnen, und mit dieser Messelektrode die Messspannung zu erfassen, die aufgrund des inversen piezoelektrischen Effekts durch die ausgeübte Kraft erzeugt wird. Da die Messspannung mit zunehmender ausgeübter Kraft ansteigt, kann für die zu erfassende Messspannung ein Schwellwert definiert werden, der der gewünschten Auslösekraft zugeordnet ist. Erreicht die ausgeübte Kraft die Auslösekraft und übersteigt die Messspannung dabei den Schwellwert, so erkennt dies eine Messeinheit, die mit den Messelektroden verbunden ist. Beim Erreichen der Auslösekraft wird dann über einen Spannungsgenerator eine Aktorspannung erzeugt und an die Aktorelektroden angelegt. Gleichzeitig wird eine weitere Aktion ausgelöst, die zum Betrieb der Vorrichtung oder eines damit verbundenen elektrischen Bauelements dient.

Die Vorrichtung stellt also praktisch einen Schalter dar, dessen Auslösepunkt über den Schwellwert eingestellt werden kann. Gleichzeitig erzeugt der Schalter ein haptisches Feedback, an dem der Nutzer, der die Kraft beispielsweise mittels eines Fingerdrucks ausübt, das Erreichen der Auslösekraft und damit den Schaltvorgang erkennt. Möglich ist auch, mehrere Schwellwerte zu definieren und mittels einer Steuerung unterschiedliches haptisches Feedback zu erzeugen, so dass unterschiedliche Auslösekräfte erkannt, in unterschiedliche Aktionen umgesetzt und über unterscheidbares Feedback an den Nutzer übermittelt werden können.

Als Messelektroden können wie gesagt die Aktorelektroden dienen. Als Messelektrode kann auch eine dritte Elektrode verwendet werden und die Messspannung zwischen der Messelektrode und einer Aktorelektrode abgegriffen werden. Möglich ist es jedoch auch, zwei separate Messelektroden im Grundkörper vorzusehen.

Die zumindest eine von den Aktorelektroden verschiedene Messelektrode kann mittig im Grundkörper zwischen ersten und zweiten Aktorelektroden angeordnet sein. Möglich ist es jedoch auch, die zumindest eine Messelektrode in der Nähe einer der beiden Hauptoberflächen anzuordnen, so dass alle anderen ersten und zweiten Aktorelektroden auf der gleichen Seite der Messelektrode im Grundkörper angeordnet sind.

Der Abstand zwischen den Messelektroden beziehungsweise zwischen den als Messelektroden verwendeten Elektroden, von denen zumindest eine Aktorelektrode sein kann, kann vorteilhaft größer gewählt werden als der Abstand zwischen den ausschließlich als erste und zweite Aktorelektroden verwendeten Elektroden. Wenn zwischen den Messelektroden, zwischen denen ja ebenfalls piezoelektrisches Material angeordnet ist, ein größerer Abstand vorgesehen wird als zwischen den reinen Aktorelektroden, so erzeugt die gleiche einwirkende Kraft bei dem zwischen den Messelektroden angeordneten piezoelektrischen Element eine höhere Spannung als bei dem piezoelektrischen Element zwischen den Aktorelektroden. Eine höhere erzeugte Messspannung hat den Vorteil, dass ein geringerer Schwellwert für die Messspannung detektiert werden kann, der der Auslösekraft zugeordnet wird.

Eine erfindungsgemäße Vorrichtung benötigt zur Erzeugung einer wahrnehmbaren Auslenkung eine bestimmte Anzahl übereinander gestapelter Piezoelemente, die alternierend zwischen ersten und zweiten Aktorelektroden angeordnet sind. So bildet sich jeweils zwischen einer ersten und einer zweiten Aktorelektrode ein Piezoelement aus. Über die Anzahl der Piezoelemente kann bei gleicher Gesamthöhe des Grundkörpers beziehungsweise bei gleicher Gesamtschichtdicke der einzelnen Piezoelemente die Aktorspannung eingestellt werden, die zum Erreichen einer bestimmten Längenausdehnung erforderlich ist. Eine große Schichtdicke zwischen zwei Aktorelektroden erfordert eine hohe Spannung zur Auslenkung. Viele kleine, gestapelte Piezoelemente erfordern eine geringere Spannung und erzeugen dennoch die gleiche Ausdehnung, wenn die Gesamthöhe der piezoelektrisch wirksamen Schichten übereinstimmt.

Erste und zweite Aktorelektroden sind vorzugsweise alternierend angeordnet und werden nach außen hin jeweils mit einem Außenkontakt verbunden, der für erste und zweite Aktorelektroden an unterschiedlichen Seiten des Grundkörpers angeordnet ist. An die beiden Außenkontakte kann dann die Aktorspannung angelegt werden.

In entsprechender Weise kann auch die zumindest eine Messelektrode mit einem Außenkontakt verbunden werden. Zum Erkennen der ausgeübten Kraft genügt jedoch ein einziges piezoelektrisches Element, zwischen dessen beiden Elektroden die Messspannung aufgrund des inversen piezoelektrischen Effekts entsteht.

Ein in der erfindungsgemäßen Vorrichtung verwendeter Grundkörper weist eine Abmessung in Richtung seiner Normalen auf, die relativ zur Abmessung vertikal dazu gering ist. Es handelt sich somit um einen flachen Grundkörper.

Beispielsweise kann die maximale Ausdehnung des Grundkörpers in eine Richtung senkrecht zur Normalen mehr als zehn Mal so groß sein wie die in Richtung der Normalen gemessene Höhe des Grundkörpers. Die Länge des Grundkörpers kann die Höhe des Grundkörpers auch um den Faktor 20 und mehr übertreffen.

Die Längenausdehnung des Grundkörpers infolge des piezoelektrischen Effekts ist relativ gering und beträgt nur ca. 0,1 Prozent der gesamten piezoelektrisch wirksamen Höhe. Durch die Zymbeln wird das Ausmaß der Längenausdehnung in Richtung der Normalen verstärkt.

Die Gesamtausdehnung der erfindungsgemäßen Vorrichtung kann weiter verstärkt werden, wenn mehrere Vorrichtungen übereinander gestapelt werden. Es wird also eine Anzahl von zwei und mehr Grundkörpern übereinander gestapelt, die auf den Hauptoberflächen jeweils mit einer Zymbel versehen sind. Vorzugsweise sind die Grundkörper mit den Zymbeln zwischen einer Betätigungsplatte und einer Basis mittels Spiralfedern fixiert. Die Federn können unter Zug- oder Druckspannung stehen und daher die Betätigungsplatte in Richtung Basis ziehen oder drücken. Bei mehreren übereinander gestapelten Grundkörpern ist die Betätigungsplatte besonders vorteilhaft, da sie gleichzeitig eine verbesserte Halterung für die Grundkörper darstellt und so ein seitliches Abkippen des Stapels verschiedener Grundkörper übereinander verhindert wird.

Noch besser und vorteilhafter ist es jedoch, wenn die übereinander gestapelten Grundkörper in einer Art Hülse geführt werden, in der sich die Betätigungsplatte in Richtung der Normalen frei bewegen kann. Ein übergebördelter Rand der Hülse an der von der Basis entfernten Seite der Hülse kann gleichzeitig dazu dienen, zwischen dem Rand und der Betätigungsplatte eine unter Druckspannung stehende Feder einzuspannen. In der Hülse kann sich die Betätigungsplatte aber auch unter Vorspannung durch eine unter Zug stehende Spiralfeder bewegen. Der genannte überstehende obere Rand der Hülse kann als Anschlag für die Längenausdehnung parallel zur Normalen dienen.

Die erfindungsgemäße Vorrichtung kann als Betätigungsknopf ausgebildet sein, mit dem eine Funktion eines elektrischen Bauelements geschaltet werden kann. Der Schaltvorgang erfolgt dann beim Erreichen und dem Erkennen der definierten Auslösekraft, wobei der Schaltvorgang entweder direkt von der Messeinheit oder von einer daran angeschlossenen Steuereinheit vorgenommen wird. Die Steuereinheit kann auch den Spannungsgenerator umfassen.

Im Folgenden wird die Erfindung anhand von Ausführungsbeispielen und der dazugehörigen Figuren näher erläutert. Die Figuren sind dabei nur schematisch ausgeführt und nicht maßstabsgetreu. Einzelne Dimensionen können daher zur besseren Verständnis vergrößert oder verkleinert dargestellt sein.
Figur 1 zeigt einen als Aktor fungierenden Grundkörper im schematischen Querschnitt.
Figur 2 zeigt einen mit aufgeklebten Zymbeln versehenen Grundkörper.
Figur 3A zeigt einen Grundkörper, der zwischen einer Betätigungsplatte und der Basis mittels Zugfedern verspannt ist.
Figur 3B zeigt einen Grundkörper, der zwischen einer Betätigungsplatte und der Basis mittels Druckfedern verspannt ist.
Figur 4 zeigt eine räumliche Darstellung einer erfindungsgemäßen Vorrichtung in der Draufsicht.
Figur 5 zeigt Grundkörper mit Messeinheit und Generator. Figuren 6A und 6B zeigen zwei verschiedene Anordnungen von Aktorelektroden und Messelektroden anhand eines schematischen Querschnitts durch den Grundkörper.
Figur 7 zeigt eine erfindungsgemäße Vorrichtung mit einem Grundkörper, der von einem durchgehenden Loch durchbrochen ist.
Figur 8 zeigt eine erfindungsgemäße Vorrichtung, bei der mehrere Grundkörper übereinander gestapelt und fixiert sind.
Figur 9 zeigt eine erfindungsgemäße Vorrichtung mit einem Grundkörper, bei der über der oberen Zymbel eine Membran verspannt ist.

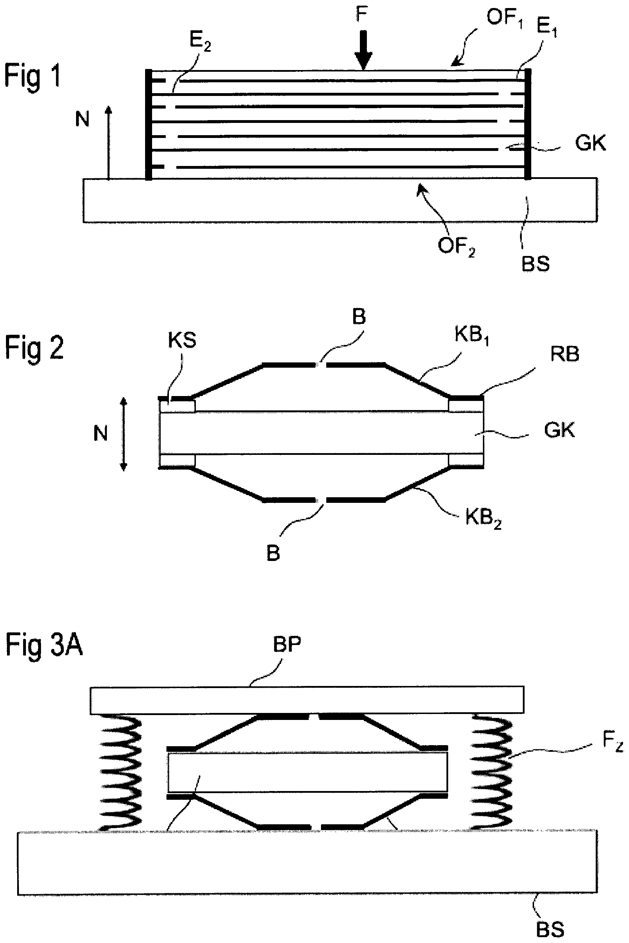

Figur 1 zeigt einen einfachen piezoelektrischen Grundkörper GK mit einer ersten und einer zweiten Aktorelektrode E1, E2. Der Grundkörper GK ist beispielsweise in Form von Übereinanderstapeln von piezoelektrischen Schichten erzeugt, die jeweils mit Elektrodenmaterial bedruckt sind oder werden. Die Schichten werden vorzugsweise als keramische Grünfolien eingesetzt und mit einer einbrennbaren Elektrodenpaste für die Aktorelektroden bedruckt. Nach Übereinanderstapeln einer gewünschten Menge an Schichten werden diese abschließend gemeinsam zu einem monolithischen Block - dem Grundkörper - gesintert. Der Aktor (= Grundkörper mit Aktorelektroden) umfasst eine Piezokeramik, beispielsweise auf der Basis von PZT (Bleizirkonat-Titanat). Die PZT-Keramik kann ferner zusätzlich Nd und Ni enthalten. Alternativ kann die PZT-Keramik ferner zusätzlich Nd, K und gegebenenfalls Cu aufweisen. Alternativ können die piezoelektrischen Schichten eine Pb(ZrₓTi₁₋ₓ)O₃ + y Pb(Mn_{1/3}Nb_{2/3})O₃ enthaltenden Zusammensetzung aufweisen. Die piezoelektrischen Schichten können so polarisiert sein, dass durch das Anlegen einer Wechselspannung zwischen den ersten und den zweiten Innenelektroden und dem damit verbundenen piezoelektrischen Effekt, die Längenänderung des Grundkörpers hervorgerufen wird.

Der Grundkörper ist auf einer Basis BS angeordnet, die beispielsweise eine Oberfläche eines elektrischen Bauelements bildet. Die Stapelrichtung der einzelnen Schichten entspricht der Oberflächennormalen N des Grundkörpers. Die auf dem Piezoaktor ausgeübte Kraft F wirkt mit ihrem vertikal zur Oberfläche beziehungsweise parallel zur Normalen N wirkenden Anteil. Nur diese Kraft wird in eine elektrische Spannung umgesetzt, die an den Aktorelektroden E1, E2 abgreifbar ist, beziehungsweise an Messelektroden, die in der Figur nicht dargestellt sind.

Zum Erzeugen des haptischen Feedbacks wird zwischen erster Aktorelektrode E1 und zweiter Aktorelektrode E2 eine Aktorspannung angelegt, die zu einer Längenänderung des Grundkörpers GK führt. Durch entsprechende Polung des piezoelektrischen Grundkörpers kann die dadurch bewirkte Längenänderung parallel zur Normalen erfolgen, also gegenläufig zur ausgeübten Kraft F, so dass sie von einem Nutzer am besten wahrgenommen werden kann.

Figur 2 zeigt anhand eines schematischen Querschnitts, wie die Längenausdehnung der gesamten Vorrichtung in Richtung der Normalen verstärkt werden kann. Auf beiden Hauptoberflächen des Grundkörpers GK ist jeweils eine als kegelstumpfförmiges Blech ausgebildete Zymbel KB1, KB2 montiert. Dazu ist ein flach ausgeführter Randbereich, der flach auf der Hauptoberfläche des Grundkörpers GK aufliegen kann, fest mit diesem verbunden. Der Randbereich ist mittels einer Klebstoffschicht KS auf dem Grundkörper GK aufgeklebt. Vorzugsweise ist die Zymbel mittels einer ihren gesamten Randbereich umlaufenden ringförmig geschlossenen Klebstoffschicht KS auf dem Grundkörper aufgeklebt. Vorzugsweise wird zum Aufkleben ein Epoxid haltiger Klebstoff verwendet, der thermisch härtbar ist. Die Härtung kann dann beispielsweise bei ca. 150°C erfolgen.

Durch die besondere Ausformung, insbesondere durch die Mantelflächen und die Deckfläche des Kegelstumpfs, wird eine Querkontraktion des Grundkörpers GK direkt in eine Verformung der Zymbel umgesetzt, die parallel zur Normalen N verläuft.

Auf einer oder vorzugsweise beiden Hauptoberflächen ist eine Zymbel aufgeklebt. Jede Zymbel weist eine vorzugsweise mittig angeordnete Bohrung auf, damit ein Druckausgleich zwischen dem unter der Zymbel eingeschlossenen Hohlraum und der Umgebung möglich wird. Die Bohrung weist einen ausreichenden Durchmesser von z.B. 0,1mm bis 0,7mm, vorzugsweise 0,3 bis 0,5mm auf.

Das Blech der Zymbel kann als Material Titan umfassen oder aus Titan bestehen. Titan weist insbesondere für die hier vorliegende Anwendung der Vorrichtung zur Erzeugung eines aktiven haptischen Feedbacks wesentliche Vorteile auf. Außerdem weist Titan einen thermischen Ausdehnungskoeffizienten auf, der sehr nahe an dem thermischen Ausdehnungskoeffizienten des Grundkörpers liegt. Dadurch wird die Verbindungsstelle des Blechs mit dem Grundkörper bei einer Veränderung der Temperatur nicht wesentlich mechanisch belastet. Beispielsweise können sowohl das Blech als auch der Grundkörper einen thermischen Ausdehnungskoeffizienten zwischen 8 und 9 ppm/K aufweisen.

Figur 3A zeigt eine Ausführungsform der erfindungsgemäßen Vorrichtung, bei der der Piezoaktor beziehungsweise der Grundkörper GK mit den beiden Zymbeln KB1, KB2 zwischen der Basis BS und einer Betätigungsplatte BP fixiert ist. Die Fixierung erfolgt durch Spiralfedern F_{Z}, die unter Zugspannung stehen und mit deren Hilfe die Betätigungsplatte BP in Richtung Basis BS gezogen wird und so den Grundkörper GK fixiert. Auf diese Weise kann sich der keramische Grundkörper GK ungehindert bewegen und eine starre Befestigung der Keramik des Grundkörpers an der Basis BS oder an eine zu bewegende Fläche kann entfallen. Dies gestattet es, das Übersetzungsvermögen der beiden kegelstumpfförmigen Zymbeln KB voll auszunutzen und mindert dabei gleichzeitig das Risiko, die Keramik beziehungsweise den Grundkörper zu beschädigen. Durch die Verspannung über die Federn FZ ist stets ein direkter Kontakt der kegelstumpfförmigen Bleche mit der Betätigungsplatte beziehungsweise mit der Basis BS gewährleistet und über die Lebensdauer und die Betriebsbedingungen, bei der die Vorrichtung betrieben wird, sichergestellt.

Die Betätigungsplatte BP ist beispielsweise rechteckig und aus Aluminium ausgebildet. Sie weist eine für die einwirkenden Kräfte ausreichende mechanische Stabilität bzw. Dicke auf. Sie kann aber auch aus anderen Materialien ausgebildet sein, z.B. aus Metall, Kunststoff, Keramik, Glas oder Holz. Dabei ist sie so ausgebildet, dass das haptische Feedback möglichst störungsfrei bzw. ohne Dämpfung übertragen werden kann. Dies setzt ein Material mit einer gewissen Härte bzw. einem hohen E-Modul voraus.

Die Betätigungsplatte BP weist eine größere Grundfläche als der Grundkörper GK auf und steht vorzugsweise allseitig über dessen Rand über. Eine sichere Fixierung wird mit zumindest zwei Federn F_{Z} erreicht. Vorteilhaft ist es jedoch, eine höhere Anzahl von Federn F_{Z} einzusetzen, um eine symmetrische Verspannung zu ermöglichen. Die Federn F_{Z} sind dann gleichmäßig über den Umfang der Betätigungsplatte verteilt.

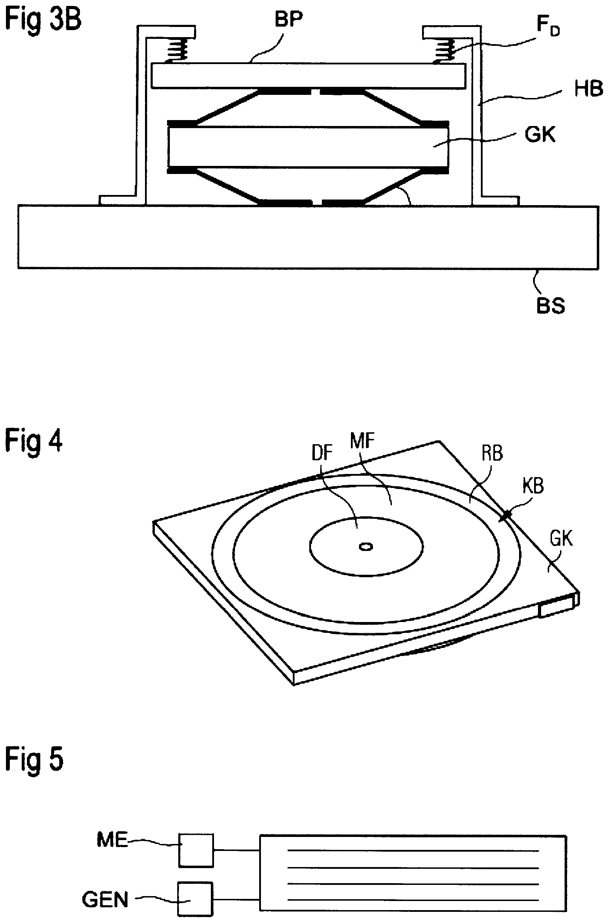

Ähnliche Vorteile wie mit der Ausführungsform nach Figur 3A werden mit einer weiteren Ausführungsform gemäß Figur 3B erzielt. In dieser Ausführungsform wird der Grundkörper GK mit den beiden Zymbeln KB ebenfalls zwischen der Betätigungsplatte BP und der Basis BS unter Druck fixiert, wobei mit Hilfe von Spiralfedern F_{D} der Druck zum Fixieren jedoch von oben auf die Betätigungsplatte BP einwirkt. Die Spiralfedern F_{D} sind unter Druckspannung zwischen der Betätigungsplatte und Haltebügeln HB eingespannt. Die Haltebügel HB ragen über die Betätigungsplatte BP und bilden dort einen Ansatzpunkt für die Federn F_{D}.

In der Figur 3B ist der Bügel im Querschnitt dargestellt. Pro Feder kann ein einzelner Haltebügel eingesetzt werden. Vorteilhaft ist es jedoch, eine Bügelleiste zu verwenden, die einen in der Figur 3B dargestellten oder ähnlichen Querschnitt aufweist, an der mehrere Federn F_{D} angreifen können.

Noch besser ist es, wenn die Schiene, die im Querschnitt den Haltebügel HB bildet, rund um die Betätigungsplatte umläuft, so dass die Betätigungsplatte quasi wie in einer Hülse bei offenem Haltebügel gehalten wird. Diese Ausführung hat den Vorteil, dass selbst bei starker Auslenkung immer noch ein sicherer Halt gewährleistet ist. Während die unter Zugspannung stehenden Federn F_{Z} der Ausführung gemäß Figur 3A gegebenenfalls überdehnt werden können, was zu einer schwächeren oder nachlassenden Fixierung führt, ist mit der Ausführung nach Figur 3B über den Haltebügel HB ein Anschlag vorgesehen, der ein zu starkes Ausweichen der Betätigungsplatte BP nach oben verhindert.

Figur 4 zeigt eine dreidimensionale Darstellung einer erfindungsgemäßen Vorrichtung in schräger Draufsicht. Der Grundkörper GK weist vorteilhaft eine quadratische Grundfläche auf, während das kegelstumpfförmige Blech KB eine runde Grundfläche aufweist, die mit ihrem Randbereich zentral auf der Oberfläche des Grundkörpers GK befestigt ist. Im Bereich der Mantelfläche MF verläuft das kegelstumpfförmige Blech nach oben und verjüngt sich radial, so dass die Deckfläche DF ebenfalls eine runde Grundfläche aufweist. Die Deckfläche DF kann plan sein, kann aber eine fingerförmige in Richtung Grundkörper weisende Vertiefung aufweisen, um sich der Fingerform eines Nutzers anzupassen.

Figur 5 zeigt einen Grundkörper GK im schematischen Querschnitt. Dargestellt sind die Aktorelektroden E1, E2, die als Innenelektroden parallel zueinander und parallel zu den Hauptoberflächen des Grundkörpers in gleichem Abstand zueinander ausgerichtet sind. Nicht dargestellt ist eine spezielle Messelektrode, die einen größeren Abstand zur benachbarten Aktorelektrode aufweisen kann. Ebenfalls nicht dargestellt ist die Verbindung der Aktorelektroden mit Außenkontakten, über die die Aktorelektroden parallel verschaltet sein können. Dazu können die Innenelektroden stegförmig bis zum Rand des Grundkörpers verlängert sein und dort einen der beiden Anschlusskontakte kontaktieren. Dieses Herausführen der Innenelektroden zu den Kanten des Grundkörpers GK erfolgt alternierend für erste und zweite Aktorelektrode hin zu unterschiedlichen Anschlusskontakten, so dass über insgesamt zwei Anschlusskontakte sämtliche erste und zweite Aktorelektroden kontaktiert werden können.

Zumindest zwei der Innenelektroden des Grundkörpers sind mit einer Messeinheit ME verbunden, die eine elektrische Spannung erkennen kann, die durch Ausüben einer Kraft vertikal auf eine Hauptoberfläche des Grundkörpers einwirkt und durch den inversen piezoelektrischen Effekt in der piezoelektrischen Keramik erzeugt wird. Ein Spannungsgenerator GEN ist mit den beiden Außenkontakten von ersten und zweiten Aktorelektroden E1, E2 verbunden. Wird von der Messeinheit ME das Erreichen einer Auslösekraft erkannt, die sich im Überschreiten der erzeugten Messspannung manifestiert, wird vom Spannungsgenerator GEN eine Aktorspannung erzeugt und an erste und zweite Aktorelektroden angelegt. Diese wiederum führen zur Auslenkung des Grundkörpers, der als haptisches Feedback vom Nutzer erkannt wird.

Um die Wahrnehmung zu verstärken, kann die an die Aktorelektroden angelegte Spannung in Form verschiedener, aufeinander folgender Pulse moduliert werden. Deren Abfolgefrequenz wird dann so gewählt, dass das Feedback als eine Vibration vom Nutzer wahrnehmbar ist. Möglich ist es auch, an die Aktorelektroden eine Wechselspannung geeigneter Frequenz anzulegen. Weiterhin ist es möglich, dass in der Messeinheit und der damit verbundenen Steuereinheit mehrere Schwellwerte definiert sind, die in der Folge unterschiedliche Feedbacks erzeugen können. Unterschiedliche Feedbacks können sich in der Frequenz oder allgemein in der Länge, Abfolgefrequenz oder Anzahl der Pulse unterscheiden. Parallel dazu kann die Vorrichtung dann abhängig von dem erreichten Schwellwert unterschiedliche Aktionen auslösen.

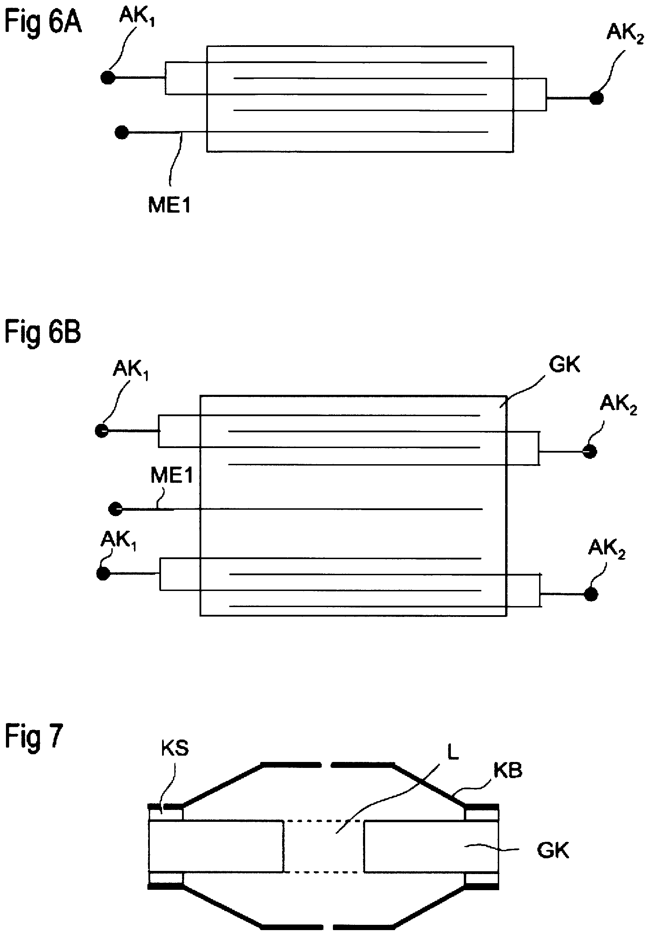

Figur 6A zeigt eine mögliche Anordnung der Messelektrode ME1 im Grundkörper GK so, dass alle Aktorelektroden auf einer Seite der Messelektrode ME1 angeordnet sind. Die Messelektrode ME1 kann dann in der Nähe einer Hauptoberfläche des Grundkörpers GK angeordnet sein.

Figur 6B zeigt anhand eines schematischen Querschnitts, wie die Messelektrode ME1 in der Mitte des Grundkörpers GK zwischen den Aktorelektroden E1, E2 angeordnet ist. Zwischen Messelektrode ME1 und Aktorelektrode E2 kann ein größerer Abstand vorgesehen sein als zwischen Aktorelektroden E1, E2 unterschiedlicher Polarität. Die ersten Aktorelektroden E1 sind mit einem ersten Außenkontakt Ak1, die zweiten Aktorelektroden E2 mit einem zweiten Außenkontakt AK2 verbunden.

Figur 7 zeigt eine weitere Ausführungsform der Erfindung, bei der keramische Grundkörper GK, also das piezoelektrische Material des Grundkörpers in der Mitte durchbrochen ist, vorzugsweise in Form eines durchgehenden zylinderförmigen Loches L. Der Randbereich des kegelstumpfförmigen Bleches KB ist in ausreichendem Abstand zu den Rändern des Loches an den Hauptoberflächen des Grundkörpers aufgeklebt. Das Loch hat den Vorteil, dass es die sich zwischen den Aktorelektroden aufbauende Kapazität des piezoelektrischen Aktors reduziert und so die Funktion des Aktors mit geringerer Leistung bei unverändert hoher Längenausdehnung möglich wird.

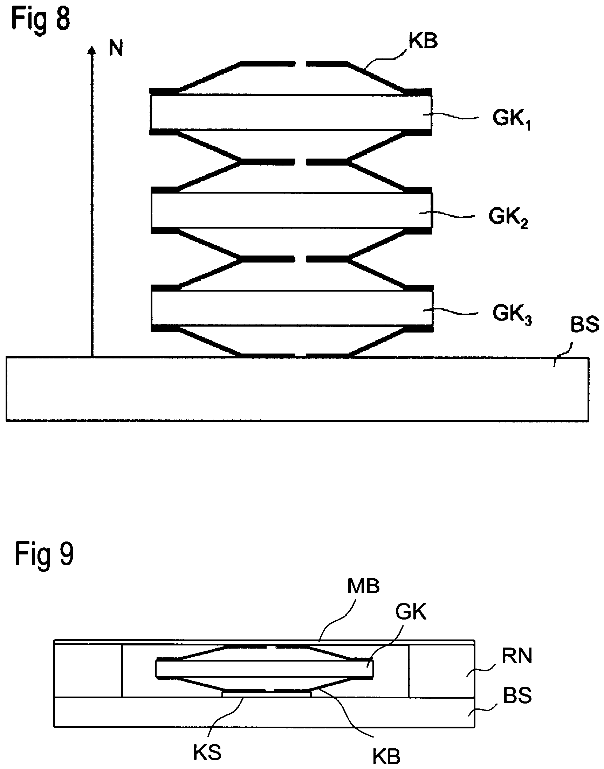

Figur 8 zeigt eine weitere Ausführungsform, bei der mehrere Vorrichtungen, umfassend jeweils mit zwei kegelstumpfförmigen Blechen KB versehene Grundkörper GK vertikal übereinander gestapelt sind, so dass die Seitenkanten sämtlicher Grundkörper miteinander fluchten, sich die Grundflächen also zu 100 Prozent überdecken. Obwohl nicht dargestellt, ist es in dieser Ausführungsform besonders vorteilhaft, eine Fixierung dieser übereinander gestapelten Vorrichtungen mit Hilfe einer Betätigungsplatte und mit Spiralfedern gegen die Basis BS zu fixieren, auf der der Stapel aufliegt. Vorteilhaft ist es hier, die Grundkörper auch seitlich über Haltebügel zu fixieren, beziehungsweise deren seitliches Verrutschen durch entsprechend nahestehende Haltebügel oder andere Anschläge zu begrenzen. Auch auf diese Weise wird gewährleistet, dass die Grundkörper maximal beweglich sind, dass die Längenausdehnung nicht gehindert ist und dass sich die Längenausdehnung der einzelnen Vorrichtungen additiv zu einer Gesamtauslenkung parallel zur Normalen N vertikal über der Oberfläche der Basis B addieren.

Figur 9 zeigt ein weiters Ausführungsbeispiel einer erfindungsgemäßen Vorrichtung, die einen Grundkörper GK aufweist. Über der oberen Zymbel ist eine Membran MB verspannt. Diese ist dünn und flexibel ausgeführt. Durch diese Verspannung und die Elastizität übt die Membran eine gegen die Basis BS wirkende Kraft aus, die einer Federkraft entspricht. Die Membran MB stellt die für den Benutzer sichtbare und bedienbare Oberfläche dar. Dies hat den Vorteil, dass die Bedienoberfläche spaltenlos ist.

Membran und Basis sind fest miteinander verbunden. Dies kann z.B. durch eine Verschraubung erfolgen (in der Figur nicht dargestellt). Die Membran kann auch über einen Rahmen RN gespannt sein, der auf der Basis fixiert ist. Damit wird eine ebene Bedienoberfläche erhalten. Gleichzeitig garantiert die dünne Membran, dass das haptische Feedback durch die Membran nicht abgeschwächt wird. Die Basis ist dagegen ist als steifer Körper ausgebildet.

Der gezeigte Aufbau stellt sicher, dass bei Betätigung der Vorrichtung ausschließlich die Membran verformt wird und damit die Stärke der haptischen Rückmeldung für den Benutzer maximiert wird. Zusätzlich kann die Federwirkung der Membran durch Variation der Dicke oder der Verbindung zwischen Membran MB und Basis BS optimiert werden.

Die Membran ist vorteilhaft so ausgebildet, dass sie eine Steifigkeit aufweist, die im Bereich von 1% - 50% der Steifigkeit des Aktors liegt.

Um ein Verrutschen des Aktuators im Betrieb zu verhindern kann dieser zusätzlich an Rückwand (und/oder Membran) befestigt werden. Eine mögliche Befestigungsweise ist die Fixierung des Aktuators mittels einer Klebeschicht KS.

Neben der insbesondere in Figur 4 dargestellten Ausführungsform mit einem Grundkörper GK rechteckiger oder quadratischer Grundfläche ist es auch möglich, den Grundkörper mit runder Grundfläche auszuführen. Die quadratische oder rechteckige Ausführung hat lediglich verfahrenstechnische Vorteile, wenn der Grundkörper aus einem großflächigeren Stapel herausgeschnitten wird, was mit geraden Schnitten erfolgt, die zu rechteckigen oder quadratischen Grundkörpern führen. Dem entsprechend kann ein Grundkörper eine Seitenlänge zwischen 10 und 30 mm aufweisen, die auch den Abmessungen eines rund ausgeführten Grundkörpers entsprechen kann. Der Grundkörper kann in Richtung der Normalen eine Höhe zwischen 0,5 und 2 mm aufweisen.

Die Zymbel KB kann so dimensioniert werden, dass der Abstand zwischen dem mittleren Bereich der Deckfläche DF und der Oberfläche des Grundkörpers GK ca. 0,5 mm beträgt, wenn keine Kraft auf das Bauelement ausgeübt wird und wenn keine Spannung zwischen ersten und zweiten Aktorelektroden anliegt.

Vorzugsweise ist der Aufbau der Vorrichtung symmetrisch, so dass oberes und unteres kegelstumpfförmiges Blech symmetrisch zueinander in ihren Abmessungen und Anordnungen sind. Die Zymbel KB weist eine maximale horizontale Ausdehnung relativ zur Grundfläche des Grundkörpers auf, so dass innerhalb des Randbereichs, der auf der Hauptoberfläche des Grundkörpers aufliegt, ein maximaler Flächeninhalt umschlossen wird. Dann ist auch das zwischen den beiden Blechen angeordnete Aktorvolumen maximal. Auf diese Weise gelingt es, eine Querkontraktion maximal zu erfassen beziehungsweise in maximaler Stärke in die gewünschte Auslenkung umzuwandeln.

Die Erfindung konnte nur anhand weniger Ausführungsbeispiele dargestellt werden und ist daher nicht auf die genaue Ausführung entsprechend der Ausführungsbeispiele beschränkt. Im Rahmen der Erfindung liegt es, die Anzahl der Aktorelektroden, die Anzahl der Anschlusskontakte oder die Anzahl übereinander gestapelter Grundkörper beliebig zu variieren. Die Ausformung der Grundfläche ist in erster Näherung auch ohne Relevanz auf die Wirksamkeit der Vorrichtung. Das haptische Feedback kann in gewünschter Weise realisiert und die Auslenkung entsprechend moduliert werden. Weiterhin kann die Auslösekraft nahezu beliebig eingestellt werden, so dass entweder nur eine leichte Berührung bis hin zu einem festen Druck zum Erreichen der gewünschten Auslösekraft erforderlich sein kann.

### Bezugszeichenliste

- AA: Aktorauslenkung
- AK: Außenkontakt
- B: Bohrung
- BS: Basis
- BP: Betätigungsplatte
- DF: stumpfe Kegelspitze = Deckfläche
- E1, E2: erste und zweite Aktorelektrode
- F: auf den Aktor ausgeübte Kraft
- F_{D}, F_{S}: Feder mit Druck- oder Zugvorspannung
- GEN: Spannungsgerators
- GK: piezoelektrischer Grundkörper
- HB: Haltebügel
- KB: kegelstumpfförmiges Blech/Zymbel
- KS: Klebstoffschicht
- L: Loch im Grundkörper
- ME: Messeinheit
- ME1, ME2: erste und zweite Messelektrode
- MF: Mantelfläche des Blechs
- MN: Membran
- N: Normale zur Hauptoberfläche
- OF₁, OF₂: Hauptoberflächen des Grundkörpers
- RB: Randbereich des Blechs
- RN: Rahmen

## Patentansprüche

1. Vorrichtung zur Erzeugung eines aktiven haptischen Feedbacks,
aufweisend einen piezoelektrischen Aktor mit einem flachen piezoelektrischen Grundkörper (GK) mit planparallelen Hauptoberflächen in einer xy Ebene und ersten und zweiten Aktorelektroden,
mit einem auf einer der Hauptoberflächen fest aufgeklebten Zymbel (KB), die als kegelstumpfförmiges Blech geformt ist,
wobei die stumpfe Kegelspitze der Zymbel (KB) vom Grundkörper weg weist
wobei zwischen der Zymbel (KB) und dem Grundkörper (GK) ein Hohlraum eingeschlossen ist,
wobei eine Bohrung (B) in der Zymbel vorgesehen ist, die einen Druckausgleich des Hohlraums mit der Umgebung ermöglicht,
wobei auf beiden Hauptoberflächen des Grundkörpers (GK) je eine Zymbel (KB) angeordnet ist,
**dadurch gekennzeichnet dass**
die beiden Zymbel (KB) über ihre Kegelstümpfe zwischen einer Basis (BS) und einer Betätigungsplatte (BP) fixiert sind, wobei die Betätigungsplatte mit der Basis in Verbindung steht und mittels einer Vorspannung fixiert ist.

2. Vorrichtung gemäß Anspruch 1,
bei dem die Zymbel (KB) aus einem Titanblech geformt ist.

3. Vorrichtung gemäß Anspruch 1 oder 2,
wobei die Zymbel (KB) einen flachen Randbereich (RB) aufweist, der planparallel zur Hauptoberflächen des Grundkörpers (GK) ausgerichtet ist, wobei die Zymbel über ihren Randbereich mit dem Grundkörper verklebt ist.

4. Vorrichtung nach einem der vorangehenden Ansprüche,
wobei die Zymbel (KB) so ausgebildet ist, dass eine Auslenkung des Grundkörpers (GK) in der xy Ebene der Hauptoberfläche eine Verformung der Zymbel erzwingt, die in einer Auslenkung in z-Richtung resultiert und so ein aktives haptisches Feedback auf die Auslenkung des Grundkörpers darstellt.

5. Vorrichtung nach einem der vorangehenden Ansprüche, wobei die Zymbel (KB) eine Mantelfläche (MF) aufweist, die in Richtung der Normalen (N) über der jeweiligen Hauptoberfläche absteht
wobei die Zymbel an der stumpfen Kegelspitze eine Deckfläche (DF) aufweist, die parallel zur Oberfläche des Grundkörpers (GK) ausgerichtet ist oder die eine anatomisch angepasste Fingermulde aufweist.

6. Vorrichtung nach einem der vorangehenden Ansprüche,
bei dem die Bohrung (B) mittenzentriert auf der stumpfen Kegelspitze angeordnet ist
bei dem die Bohrung einen Durchmesser von 0,1 bis 0,6 mm aufweist.

7. Vorrichtung nach einem der vorangehenden Ansprüche,
bei dem die Zymbel (KB) mittels eines Epoxid-Klebers auf dem Grundkörper (GK) aufgeklebt ist.

8. Vorrichtung gemäß einem der vorherigen Ansprüche,
- wobei im Grundkörper (GK) eine Messelektrode (ME1) angeordnet ist
- wobei eine Messeinheit (ME) vorgesehen ist zur Messung einer zwischen der Messelektrode und einer der Aktorektroden erzeugten Messspannung, die in Folge einer auf den Grundkörper (GK) ausgeübten Kraft entsteht, und
- wobei die Vorrichtung dazu ausgestaltet ist, diese ausgeübte Kraft zu erkennen, sobald die von der Messeinheit (ME) erfasste Messspannung einen Schwellwert übersteigt, der einer Auslösekraft zugeordnet ist
- wobei bei Erreichen der Auslösekraft mittels eines Spannungsgerators eine Aktorspannung erzeugt und an die Aktorelektroden angelegt wird und dabei gleichzeitig eine weitere Aktion ausgelöst wird, die zum Betrieb der Vorrichtung oder eines damit verbundenen elektrischen Bauelements dient.

9. Vorrichtung gemäß dem vorherigen Anspruch,
bei der die Aktorelektroden gleichzeitig auch die Messelektroden darstellen,
bei der die Messeinheit zur Bestimmung der Messspannung zwischen den beiden Aktorelektroden ausgebildet ist.

10. Vorrichtung gemäß einem der vorherigen Ansprüche,
wobei eine von den Aktorelektroden verschiedene Messelektrode entweder mittig im Grundkörper zwischen ersten und zweiten Aktorelektroden oder in der Nähe einer der Hauptoberflächen angeordnet ist, sodass alle ersten und zweiten Aktorelektroden auf einer Seite der Messelektrode angeordnet sind.

11. Vorrichtung gemäß einem der vorherigen Ansprüche,
wobei der Grundkörper ein durchgehendes Loch aufweist, das sich parallel zur Normalen zwischen den beiden Hauptoberflächen erstreckt.

12. Vorrichtung gemäß einem der vorherigen Ansprüche,
bei der über der nach außen weisende Zymbel eine Membran (MN) als Betätigungsplatte verspannt ist, die die Zymbeln (KB) und damit auch den Aktor mit einer in Richtung der Basis (BS) wirkenden Vorspannung an der Basis fixiert.

13. Vorrichtung gemäß einem der vorherigen Ansprüche, ausgebildet als Betätigungsknopf eines elektrischen Bauelements.

14. Vorrichtung gemäß einem der vorherigen Ansprüche,
wobei die Vorspannung als Zug- oder Druckspannung wirkt und über Federn eingestellt ist.

15. Vorrichtung gemäß einem der vorherigen Ansprüche,
wobei die Betätigungsplatte (BP) parallel zur Oberfläche der Basis (BS) ausgerichtet ist und auf einer Deckfläche der oberen Zymbel (KB) aufliegt, wobei die Betätigungsplatte über den Grundkörper (GK) an zumindest zwei Seiten übersteht und im überstehenden Bereich über Federn mit der Basis verbunden ist, wobei die Federn unter Vorspannung stehen.

## Claims

1. Device for generating active haptic feedback,
comprising a piezoelectric actuator having a flat piezoelectric main body (GK) having plane-parallel main surfaces in an xy plane and first and second actuator electrodes,
having a cymbal-shaped element (KB) shaped as a truncated-cone-shaped metal sheet, said cymbal-shaped element being fixedly adhesively bonded on one of the main surfaces,
wherein the truncated cone vertex of the cymbal-shaped element (KB) faces away from the main body, wherein a cavity is enclosed between the cymbal-shaped element (KB) and the main body (GK), wherein a hole (B) is provided in the cymbal-shaped element, said hole enabling pressure equalization between the cavity and the surroundings,
wherein a respective cymbal-shaped element is arranged on both main surfaces of the main body (GK), **characterized in that** the two cymbal-shaped elements (KB) are fixed between a base (BS) and an actuation plate (BP) by way of their truncated cones, wherein the actuation plate is connected to the base and is fixed by means of a preload.

2. Device according to Claim 1,
wherein the cymbal-shaped element (KB) is shaped from a titanium metal sheet.

3. Device according to Claim 1 or 2,
wherein the cymbal-shaped element (KB) comprises a flat edge region (RB) oriented plane-parallel to the main surfaces of the main body (GK),
wherein the cymbal-shaped element is adhesively bonded to the main body by way of its edge region.

4. Device according to any of the preceding claims,
wherein the cymbal-shaped element (KB) is configured such that a deflection of the main body (GK) in the xy plane of the main surface forces a deformation of the cymbal-shaped element which results in a deflection in the z-direction and thus constitutes active haptic feedback to the deflection of the main body.

5. Device according to any of the preceding claims,
wherein the cymbal-shaped element (KB) comprises a lateral surface (MF) projecting above the respective main surface in the direction of the normal (N),
wherein the cymbal-shaped element comprises a cover surface (DF) at the truncated cone vertex, which cover surface is oriented parallel to the surface of the main body (GK) or comprises an anatomically adapted finger depression.

6. Device according to any of the preceding claims,
wherein the hole (B) is arranged in a manner centred in the middle on the truncated cone vertex,
wherein the hole has a diameter of 0.1 to 0.6 mm.

7. Device according to any of the preceding claims,
wherein the cymbal-shaped element (KB) is adhesively bonded on the main body (GK) by means of an epoxy adhesive.

8. Device according to any of the preceding claims,
- wherein a measurement electrode (ME1) is arranged in the main body (GK),
- wherein a measuring unit (ME) is provided for measuring a measurement voltage which is generated between the measurement electrode and one of the actuator electrodes and which arises on account of a force exerted on the main body (GK), and
- wherein the device is configured to identify this exerted force as soon as the measurement voltage detected by the measuring unit (ME) exceeds a threshold value assigned to a trigger force,
- wherein, upon the trigger force being reached, by means of a voltage generator, an actuator voltage is generated and applied to the actuator electrodes and in this case at the same time a further action is triggered, which serves for operation of the device or of an electrical component connected thereto.

9. Device according to the preceding claim,
wherein the actuator electrodes at the same time also constitute the measurement electrodes, wherein the measuring unit is configured for determining the measurement voltage between the two actuator electrodes.

10. Device according to any of the preceding claims,
wherein a measurement electrode that is different from the actuator electrodes is arranged either centrally in the main body between first and second actuator electrodes or in the vicinity of one of the main surfaces, such that all first and second actuator electrodes are arranged on one side of the measurement electrode.

11. Device according to any of the preceding claims,
wherein the main body comprises a through hole extending parallel to the normal between the two main surfaces.

12. Device according to any of the preceding claims,
wherein a membrane (MN) is braced as an actuation plate above the cymbal-shaped element facing outward, which membrane fixes the cymbal-shaped elements (KB) and thus also the actuator with a preload acting in the direction of the base (BS) at the base.

13. Device according to any of the preceding claims,
configured as an actuation knob of an electrical component.

14. Device according to any of the preceding claims,
wherein the preload is effective as a tensile or compressive load and is set by way of springs.

15. Device according to any of the preceding claims,
wherein the actuation plate (BP) is oriented parallel to the surface of the base (BS) and bears on a cover surface of the upper cymbal-shaped element (KB), wherein the actuation plate projects beyond the main body (GK) at at least two sides and is connected to the base in the projecting region by way of springs, wherein the springs are under preload.

## Revendications

1. Dispositif permettant de générer une rétroaction haptique,
présentant un actionneur piézoélectrique doté d'un corps de base piézoélectrique plat (GK) à surfaces principales planes et parallèles dans un plan xy et avec des premières et des deuxièmes électrodes d'actionneur,
comprenant une cymbale (KB) en forme de tôle tronconique, solidement collée sur l'une des surfaces principales,
la pointe de cône tronquée de la cymbale (KB) étant détournée du corps de base,
une cavité étant enfermée entre la cymbale (KB) et le corps de base (GK),
un alésage (B) étant prévu dans la cymbale qui permet une compensation de pression de la cavité avec l'environnement,
respectivement une cymbale (KB) étant disposée sur les deux surfaces principales du corps de base (GK),
**caractérisé en ce que** les deux cymbales (KB) sont fixées par l'intermédiaire de leurs troncs de cône entre une base (BS) et une plaque d'actionnement (BP), la plaque d'actionnement étant reliée à la base et étant fixée au moyen d'une précontrainte.

2. Dispositif selon la revendication 1, dans lequel la cymbale (KB) est formée à partir d'une tôle de titane.

3. Dispositif selon la revendication 1 ou 2, dans lequel la cymbale (KB) présente une zone marginale plate (RB) qui est alignée de manière plane et parallèle par rapport aux surfaces principales du corps de base (GK), la cymbale étant par sa zone marginale collée au corps de base.

4. Dispositif selon l'une quelconque des revendications précédentes, dans lequel la cymbale (KB) est réalisée de telle sorte qu'une déviation du corps de base (GK) dans le plan xy de la surface principale impose une déformation de la cymbale qui aboutit à une déviation dans la direction z et représente ainsi une rétroaction haptique active à la déviation du corps de base.

5. Dispositif selon l'une quelconque des revendications précédentes,
dans lequel la cymbale (KB) présente une surface latérale (MF) qui fait saillie en direction de la normale (N) à la surface principale respective,
dans lequel la cymbale présente au niveau de la pointe de cône tronquée une surface de recouvrement (DF) qui est alignée en parallèle à la surface du corps de base (GK) ou qui présente un creux pour les doigts adapté anatomiquement.

6. Dispositif selon l'une quelconque des revendications précédentes,
dans lequel l'alésage (B) est disposé de manière centrée au milieu sur la pointe de cône tronquée,
dans lequel l'alésage présente un diamètre de 0,1 à 0,6 mm.

7. Dispositif selon l'une quelconque des revendications précédentes, dans lequel la cymbale (KB) est collée sur le corps de base (GK) au moyen d'un adhésif époxy.

8. Dispositif selon l'une quelconque des revendications précédentes, dans lequel
- une électrode de mesure (ME1) est disposée dans le corps de base (GK),
- une unité de mesure (ME) est prévue pour mesurer une tension de mesure générée entre l'électrode de mesure et l'une des électrodes d'actionneur, qui se crée suite à une force exercée sur le corps de base (GK), et
- le dispositif est configuré pour reconnaître cette force exercée dès que la tension de mesure détectée par l'unité de mesure (ME) dépasse une valeur seuil qui est associée à une force de déclenchement,
- lorsque la force de déclenchement est atteinte, une tension d'actionneur est générée au moyen d'un générateur de tension et appliquée aux électrodes d'actionneur, et en même temps, une autre action est déclenchée qui sert à faire fonctionner le dispositif ou un composant électrique relié à celui-ci.

9. Dispositif selon la revendication précédente,
dans lequel les électrodes d'actionneur représentent en même temps aussi les électrodes de mesure,
dans lequel l'unité de mesure est réalisée pour déterminer la tension de mesure entre les deux électrodes d'actionneur.

10. Dispositif selon l'une quelconque des revendications précédentes, dans lequel une électrode de mesure, différente des électrodes d'actionneur, est disposée soit au centre dans le corps de base entre des premières et des deuxièmes électrodes d'actionneur, soit à proximité d'une des surfaces principales de sorte que toutes les premières et toutes les deuxièmes électrodes d'actionneur sont disposées sur un côté de l'électrode de mesure.

11. Dispositif selon l'une quelconque des revendications précédentes, dans lequel le corps de base présente un trou traversant qui s'étend en parallèle à la normale entre les deux surfaces principales.

12. Dispositif selon l'une quelconque des revendications précédentes, dans lequel, au-dessus de la cymbale orientée vers l'extérieur, une membrane (MN) est tendue comme plaque d'actionnement qui fixe les cymbales (KB), et donc aussi l'actionneur, à la base par une précontrainte agissant en direction de la base (BS) .

13. Dispositif selon l'une quelconque des revendications précédentes, réalisé sous forme de bouton d'actionnement d'un composant électrique.

14. Dispositif selon l'une quelconque des revendications précédentes, dans lequel la précontrainte agit comme une force de traction ou de compression et est réglée par des ressorts.

15. Dispositif selon l'une quelconque des revendications précédentes, dans lequel la plaque d'actionnement (BP) est alignée en parallèle à la surface de la base (BS) et repose sur une surface de recouvrement de la cymbale supérieure (KB), dans lequel la plaque d'actionnement dépasse du corps de base (GK) sur au moins deux côtés et est reliée à la base par des ressorts dans la zone en saillie, les ressorts étant sous précontrainte.
